# FASCICULE DE BREVET EUROPEEN

(11) **EP 2 081 217 B1**
(45) Date de publication et mention de la délivrance du brevet: **08.05.2019**
(21) Numéro de dépôt: 09150375.5
(22) Date de dépôt: 12.01.2009
(51) Int. Cl.: H01L 21/314, H01L 21/768, H01L 29/06

(54) **Procédé de fabrication de films de carbure de silicium hydrogéné amorphe munis de pores traversants**
Herstellungsverfahren von Folien aus amorphem hydrogenisiertem Siliziumkarbid, das über durchlässige Poren verfügt
Method for manufacturing films of hydrogenated amorphous silicon carbide equipped with through pores

(30) Priorité: 16.01.2008 FR 0850247
(43) Date de publication de la demande: 22.07.2009
(73) Titulaire: Commissariat à l'Énergie Atomique et aux Énergies Alternatives, 75015 Paris (FR)
(72) Inventeur: Zenasni, Aziz, 38610 Gieres (FR)
(74) Mandataire: Ilgart, Jean-Christophe

(56) Documents cités:
- EP-A2- 0 926 724
- WO-A-2006/061318
- US-A- 6 139 626
- M. J. LOBODA: "New solutions for intermetal dielectrics using trimethylsilane-based PECVD processes" MICROELECTRONIC ENGINEERING, vol. 50, 15 mars 2000 (2000-03-15), pages 15-23, XP002493946
- K. SONNENBURG ET AL: "Synthesis and characterization of SiC materials with hierarchical porosity obtained by replication techniques" PHYS. CHEM. CHEM. PHYS., vol. 8, 2 juin 2006 (2006-06-02), pages 3561-3566, XP002493853 Internet
- FAVENNEC L ET AL: "New low k a-SiC:H dielectric barrier for advanced interconnects", INTERCONNECT TECHNOLOGY CONFERENCE, 2006 INTERNATIONAL, IEEE, PISCATAWAY, NJ, USA, 5 June 2006 (2006-06-05), pages 110-112, XP031668796, ISBN: 978-1-4244-0104-8

## Description

### DOMAINE TECHNIQUE

La présente invention se rapporte à un procédé de fabrication de films de carbure de silicium hydrogéné amorphe, encore connu sous l'appellation a-SiC:H, qui sont pourvus de pores traversants, c'est-à-dire de pores qui s'étendent d'une surface principale à l'autre de ces films.

Elle se rapporte également à l'utilisation des films de a-SiC:H à pores traversants ainsi obtenus.

De tels films ont, de par leur porosité, la propriété d'être perméables aux agents classiquement employés pour réaliser des attaques chimiques dans l'industrie des semi-conducteurs comme, par exemple, l'acide fluorhydrique, tout en étant résistants à ces agents. Ils ont également celle de présenter une faible permittivité ("*low-k*"), c'est-à-dire une constante diélectrique *k* généralement inférieure ou égale à 4,0.

Ils sont donc susceptibles d'être utilisés en microélectronique et en microtechnologie, dans tous les processus de fabrication qui font intervenir la dégradation d'un matériau sacrificiel par diffusion d'un agent d'attaque chimique au travers d'un film perméable à cet agent pour la réalisation de cavités d'air.

A titre d'exemples, de tels processus sont mis en oeuvre dans la fabrication d'interconnexions à cavités d'air (ou « air-gaps » en anglais) pour circuit intégré, de microsystèmes électromécaniques (MEMS) à cavités résonantes du type BAW (« Bulk Acoustic Wave »), ainsi que de microbatteries.

### ÉTAT DE LA TECHNIQUE ANTERIEURE

La fabrication de dispositifs en microélectronique ou en microtechnologie nécessite, dans les solutions les plus avancées, la réalisation de cavités d'air.

Pour réaliser ces cavités d'air, l'une des approches actuelles consiste à dégrader un matériau sacrificiel, typiquement de l'oxyde de silicium, au moyen d'un agent d'attaque chimique, par exemple de l'acide fluorhydrique, qui doit traverser une membrane pour atteindre ce matériau.

Outre d'être capable de laisser passer l'agent d'attaque chimique, cette membrane doit répondre à un cahier des charges très précis, à savoir :
- résister elle-même à l'agent d'attaque chimique,
- être compatible avec les différents procédés et traitements mis en oeuvre pour réaliser la structure dans laquelle elle est intégrée (métallisations, polissages mécano-chimiques, recuits thermiques, ......) et, en particulier, être stable à des températures pouvant atteindre 400°C,
- avoir des propriétés mécaniques satisfaisantes puisqu'elle participe à l'ossature de la structure, et
- présenter une constante diélectrique faible, c'est-à-dire au plus égale à 4,0, dans le cas d'une structure d'interconnexions pour circuit intégré.

Le carbure de silicium hydrogéné amorphe est un matériau potentiellement utilisable pour la réalisation de telles membranes mais à condition toutefois de pouvoir être rendu poreux.

En effet, une solution aqueuse, par exemple d'acide fluorhydrique, est incapable de pénétrer dans un film de carbure de silicium hydrogéné non poreux, non seulement en raison de l'absence de zones de pénétration mais également à cause de l'hydrophobie que présente la surface de ce film.

L'obtention d'un film de carbure de silicium hydrogéné amorphe poreux est donc un challenge en soi.

L'une des approches les plus fréquemment utilisées pour obtenir un film poreux consiste à réaliser un film composite comprenant, d'une part, une matrice formée d'un matériau polymérisable et, d'autre part, un agent porogène dispersé dans cette matrice puis, après polymérisation du matériau de la matrice, à extraire de celle-ci ledit agent porogène, par exemple par décomposition thermique.

Toutefois, cette approche n'est pas utilisable pour la réalisation de films de carbure de silicium hydrogéné amorphe poreux en raison de la nature hydrocarbonée des agents porogènes.

On connait par Sonnenburg et al. (Physical Chemistry Chemical Physics, 8, 2006, 3561-3566) un procédé de fabrication de monolithes poreux en carbure de silicium. Ce procédé consiste à infiltrer des structures préformées en silice, qui comportent des pores, avec des précurseurs carbonés, puis à carboniser ces structures dans un four pour obtenir des monolithes composites SiC-SiO₂ et à éliminer ensuite les restes de silice par un traitement par une solution de fluorure d'ammonium.

On connait, par ailleurs, par EP 0 926 724 un procédé pour former sélectivement des zones de silicium poreux dans un substrat de silicium par dépôt sur le substrat d'un masque en carbure de silicium, gravure du masque selon des motifs et anodisation des zones du substrat dépourvues de masque.

### EXPOSÉ DE L'INVENTION

L'invention a précisément pour objet un procédé selon la revendication 1 qui permet de fabriquer un film de carbure de silicium hydrogéné amorphe poreux.

Ce procédé comprend :
a) la formation sur un substrat d'un film constitué d'une matrice de carbure de silicium hydrogéné amorphe dans laquelle sont dispersés des nanofils traversants d'oxyde de silicium ; puis
b) la destruction sélective par un agent chimique des nanofils d'oxyde de silicium présents dans le film formé à l'étape a), ce qui a pour effet de transformer ces nanofils en pores ou canaux de diffusion traversants.

Conformément à l'invention, les nanofils d'oxyde de silicium présentent, de préférence, un diamètre allant de quelques nm à quelques dizaines de nm et, mieux encore, de 2 nm à 10 nm.

Par ailleurs, l'étape a) comprend, de préférence, la formation sur le substrat des nanofils d'oxyde de silicium puis la formation autour de ces nanofils de la matrice de carbure de silicium hydrogéné amorphe.

Des nanofils d'oxyde de silicium peuvent être formés sur un substrat par de nombreuses techniques bien connues de l'homme du métier et, notamment, par dépôt chimique en phase vapeur (ou CVD pour « Chemical Vapor Déposition »), décomposition thermique catalytique (ou CCVD pour « Catalytic Chemical Vapor Déposition »), réduction carbothermique, ablation laser ou encore par la voie sol-gel.

Toutefois, dans le cadre de l'invention, on préfère réaliser les nanofils par la voie sol-gel.

La matrice de carbure de silicium hydrogéné amorphe est, elle, de préférence formée par la technique de dépôt chimique en phase vapeur assisté par plasma, également connue sous le sigle PECVD pour « **P**lasma **E**nhanced **C**hemical **V**apor **D**éposition », à partir de couples de précurseurs du type triméthylsilane/ hélium ou silane/méthane. En effet, de par le fait que cette technique autorise la réalisation de dépôts à de basses pressions, elle permet de recouvrir les nanofils, sur toute leur longueur, de carbure de silicium hydrogéné amorphe, étant entendu que l'on veillera à régler la durée du dépôt du a-SiC:H de sorte que les extrémités des nanofils ne soient pas incluses dans la matrice et puissent rester ainsi accessibles à l'agent chimique.

Comme précédemment indiqué, on procède ensuite à une destruction sélective des nanofils d'oxyde de silicium au moyen d'un agent chimique pour rendre le film perméable. Cet agent chimique doit donc être capable de dégrader l'oxyde de silicium tout en conservant intacte la matrice de carbure de silicium hydrogéné amorphe.

Un composé chimique ayant cette propriété est l'acide fluorhydrique qui est couramment employé dans l'industrie des semiconducteurs et dont l'utilisation est donc parfaitement maîtrisée.

Aussi, l'agent chimique utilisé à l'étape b) est-il, de préférence, un fluide contenant de l'acide fluorhydrique.

Conformément à l'invention, ce fluide est, de préférence, une solution aqueuse ou organique d'acide fluorhydrique, par exemple à 1 ou quelques % (v/v) d'HF, auquel cas l'étape b) peut être réalisée par simple trempage du film dans cette solution.

Toutefois, il peut également s'agir d'acide fluorhydrique gazeux, pur ou mélangé à un gaz porteur tel que l'azote, ou d'un mélange d'acide fluorhydrique et de dioxyde de carbone supercritique, par exemple dans un rapport de 1/100 (v/v).

En variante, l'agent chimique peut également être un fluide contenant du fluorure d'ammonium, avantageusement en mélange avec de l'acide fluorhydrique.

L'invention permet d'obtenir un film de carbure de silicium hydrogéné amorphe, qui comprend des pores traversants.

De préférence, ce film présente une épaisseur allant de 50 nm à 10 *µ*m et, mieux encore, de 100 nm à 1 *µ*m et des pores d'un diamètre allant de quelques nm à quelques dizaines de nm et, mieux encore, de 2 nm à 10 nm.

L'invention a encore pour objet l'utilisation de ce film dans la fabrication d'une structure d'interconnexions à cavités d'air pour circuit intégré.

D'autres caractéristiques et avantages de l'invention apparaîtront mieux à la lecture du complément de description qui suit et qui se rapporte à des exemples de mise en oeuvre du procédé selon l'invention.

Bien entendu, ces exemples ne sont donnés qu'à titre d'illustrations de l'objet de l'invention et ne constituent en aucun cas une limitation de cet objet.

### EXPOSÉ DÉTAILLÉ DE MODES DE MISE EN ŒUVRE PARTICULIERS

### Exemple 1 :

On dépose, sur un wafer en silicium, une couche mince de 200 nm d'épaisseur de SiO₂ par PECVD à partir d'un mélange de triéthylorthosilane et d'oxygène.

Le dépôt est réalisé dans un réacteur à couplage capacitif du type Centura 5200 DxZ de la société Applied Materials, en utilisant les paramètres opératoires suivants :
Excitation radiofréquence : 13,56 MHz
Pression de travail : 8.2 torrs (1 kPa)
Puissance : 910 W
Température de dépôt : 400°C
Flux de triéthylorthosilane : 1000 mg/min
Flux d'oxygène : 1000 cm³/min
Durée du dépôt : 25 secondes.

Puis, on forme les nanofils de SiO₂ sur la couche mince de SiO₂.

Pour ce faire, on prépare une première solution en ajoutant graduellement 52 ml de tétraéthyl-orthosilicate (TEOS) à 115 mL d'éthanol et une deuxième solution en mélangeant 115 mL d'éthanol à 18 mL d'eau et 0,27 mL d'acide chlorhydrique. La deuxième solution est ensuite ajoutée à la première. Le mélange résultant est étalé par centrifugation sur l'empilement formé par le wafer de silicium et la couche de SiO₂ qui le recouvre, et le tout est placé dans une enceinte chauffée (200°C) pendant 12 heures.

On forme ensuite, autour des nanofils de SiO₂ ainsi obtenus, la matrice de a-SiC:H par PECVD à partir de triméthylsilane et d'hélium, par exemple dans un réacteur à couplage capacitif du type Centura® 5200 DxZ de la société Applied Materials, et en utilisant les paramètres opératoires suivants :
Excitation radiofréquence : 13,56 MHz
Pression de travail : 4 torrs (533 Pa)
Puissance : 250 W
Température de dépôt : 350-400°C
Flux de triméthylsilane : 350 cm³/min
Flux d'hélium : 4900 cm³/min
Durée du dépôt : 8 minutes.

On soumet alors la surface de la matrice ainsi formée à un polissage mécanique de la surface du film ainsi formé pendant 10 secondes, au moyen d'une suspension aqueuse basique (pH 8) de particules colloïdales de silice et en utilisant une vitesse de rotation du plateau de 80 tours/min et une pression de 2 psi (13,789 kPa).

Puis, on immerge l'empilement dans une solution aqueuse à 1% (v/v) d'acide fluorhydrique pendant 10 minutes.

On obtient ainsi un film de a-SiC:H muni de pores traversants et dont la constante diélectrique est inférieure à 4,0.

### Exemple 2 :

On dépose, sur un wafer de silicium, une couche mince de 200 nm d'épaisseur de SiO₂ par PECVD à partir d'un mélange de triéthylorthosilane et d'oxygène.

Le dépôt est réalisé dans un réacteur à couplage capacitif du type Centura® 5200 DxZ de la société Applied Materials, en utilisant les paramètres opératoires suivants :
Excitation radiofréquence : 13,56 MHz
Pression de travail : 8 torrs (1 kPa)
Puissance : 910 W
Température de dépôt : 400°C
Flux de triéthylorthosilane : 1000 mg/min
Flux d'oxygène : 1000 cm³/min
Durée du dépôt : 25 secondes.

Puis, on introduit l'empilement ainsi obtenu dans un réacteur four. On dépose de la poudre de silicium de façon uniforme sur la couche de SiO₂ et on place cette structure sur le tube en alumine du four dont on règle la pression interne à 6.10⁻² torrs (8 Pa). Le four est chauffé à la température de 800°C à raison de 10°C par minute, maintenu à cette température pendant 30 minutes, puis chauffé à 1300°C, toujours à raison de 10°C/min, et maintenu à cette température pendant 5 heures. Une fois la température de 1300°C atteinte, un flux d'argon ultrapur, c'est-à-dire présentant un degré de pureté de 99,99% avec une teneur en H₂ d'au plus 1 ppm, une teneur en H₂O d'au plus 20 ppm, une teneur en O₂ d'au plus 20 ppm et une teneur en composés hydrocarbonés d'au plus 6 ppm, est introduit dans le four, à raison de 50 cm³/min, à une pression de 300 torrs (40 kPa).

Après quoi, on forme, autour des nanofils de SiO₂ ainsi obtenus, la matrice de a-SiC:H par PECVD à partir de tétraméthylsilane et d'hélium, par exemple dans un réacteur à couplage capacitif du type Centura® 5200 DxZ de la société Applied Materials, et en utilisant les paramètres opératoires suivants :
Excitation radiofréquence : 13,56 MHz
Pression de travail : 4 torrs (533 Pa)
Puissance : 250 W
Température de dépôt : 350-400°C
Flux de tétraméthylsilane : 350 cm³/min
Flux d'hélium : 4900 cm³/min
Durée du dépôt : 8 minutes.

Puis, on soumet la surface de la matrice ainsi formée à un polissage mécano-chimique, exactement dans les mêmes conditions que celles décrites dans l'exemple 1.

On immerge alors l'empilement dans une solution aqueuse à 1% (v/v) d'acide fluorhydrique pendant 10 minutes.

On obtient ainsi un film de a-SiC:H muni de pores traversants et dont la constante diélectrique est inférieure à 4,0.

## Revendications

1. Procédé de fabrication d'un film de carbure de silicium hydrogéné amorphe à pores traversants, qui comprend :
a) la formation sur un substrat d'un film constitué d'une matrice de carbure de silicium hydrogéné amorphe dans laquelle sont dispersés des nanofils traversants d'oxyde de silicium ; puis
b) la destruction sélective par un agent chimique des nanofils d'oxyde de silicium présents dans le film formé à l'étape a).

2. Procédé selon la revendication 1, dans lequel l'étape a) comprend la formation sur le substrat des nanofils d'oxyde de silicium puis la formation autour des nanofils ainsi formés de la matrice de carbure de silicium hydrogéné amorphe.

3. Procédé selon la revendication 2, dans lequel les nanofils d'oxyde de silicium sont formés par la voie sol-gel ou par dépôt chimique en phase vapeur.

4. Procédé selon la revendication 2 ou la revendication 3, dans lequel la matrice de carbure de silicium hydrogéné amorphe est formée par dépôt chimique en phase vapeur assisté par plasma.

5. Procédé selon l'une quelconque des revendications précédentes, dans lequel l'agent chimique utilisé à l'étape b) est un fluide contenant de l'acide fluorhydrique.

6. Procédé selon la revendication 5, dans lequel le fluide contenant de l'acide fluorhydrique est une solution aqueuse ou organique d'acide fluorhydrique.

7. Procédé selon la revendication 5, dans lequel le fluide contenant de l'acide fluorhydrique est de l'acide fluorhydrique gazeux, un mélange d'acide fluorhydrique gazeux et d'un gaz porteur, ou bien un mélange d'acide fluorhydrique et de dioxyde de carbone supercritique.

8. Procédé de fabrication d'une structure d'interconnexions à cavités d'air pour circuit intégré, qui comprend la mise en oeuvre d'un procédé de fabrication d'un film de carbure de silicium hydrogéné amorphe à pores traversants selon l'une quelconque des revendications 1 à 7.

## Patentansprüche

1. Verfahren zum Herstellen einer Folie aus hydriertem amorphem Siliciumcarbid mit durchgehenden Poren, umfassend:
a) Bilden einer aus einer Matrix aus hydriertem amorphem Siliciumcarbid, in welcher durchgehende Nanodrähte aus Siliciumoxid dispergiert sind, bestehenden Folie auf einem Substrat; dann
b) selektives Zerstören der in der in Schritt a) gebildeten Folie vorhandenen Nanodrähte aus Siliciumoxid durch ein chemisches Mittel.

2. Verfahren nach Anspruch 1, wobei der Schritt a) das Bilden von Nanodrähten aus Siliciumoxid auf dem Substrat, dann das Bilden der Matrix aus hydriertem amorphem Siliciumcarbid um die so gebildeten Nanodrähte herum umfasst.

3. Verfahren nach Anspruch 2, wobei die Nanodrähte aus Siliciumoxid durch ein Sol-Gel-Verfahren oder durch chemische Gasphasenabscheidung gebildet werden.

4. Verfahren nach Anspruch 2 oder Anspruch 3, wobei die Matrix aus hydriertem amorphem Siliciumcarbid durch plasmagestützte chemische Gasphasenabscheidung gebildet wird.

5. Verfahren nach einem der vorangehenden Ansprüche, wobei das in Schritt b) verwendete chemische Mittel ein fluorwasserstoffsäurehaltiges Fluid ist.

6. Verfahren nach Anspruch 5, wobei das fluorwasserstoffsäurehaltige Fluid eine wässrige oder organische Fluorwasserstoffsäurelösung ist.

7. Verfahren nach Anspruch 5, wobei das fluorwasserstoffsäurehaltige Fluid eine gasförmige Fluorwasserstoffsäure, ein Gemisch aus gasförmiger Fluorwasserstoffsäure und einem Trägergas oder ein Gemisch aus Fluorwasserstoffsäure und superkritischem Kohlendioxid ist.

8. Verfahren zum Herstellen einer Verbindungsstruktur mit Lufteinschlüssen für integrierte Schaltungen, das das Durchführen eines Verfahrens zum Herstellen einer Folie aus hydriertem amorphem Siliciumcarbid mit durchgehenden Poren nach einem der Ansprüche 1 bis 7 umfasst.

## Claims

1. Process for fabricating a hydrogenated amorphous silicon carbide film with through-pores, which comprises:
a) the formation on a substrate of a film consisting of an amorphous hydrogenated silicon carbide matrix in which silicon oxide through-nanowires are dispersed; then
b) the selective destruction by a chemical agent of the silicon oxide nanowires present in the film formed at step a).

2. Process according to claim 1, in which step a) comprises the formation of the silicon oxide nanowires on the substrate followed by the formation of the amorphous hydrogenated silicon carbide matrix around the nanowires thus formed.

3. Process according to claim 2, in which the silicon oxide nanowires are formed by the sol-gel route or by chemical vapour deposition.

4. Process according to claim 2 or claim 3, in which the amorphous hydrogenated silicon carbide matrix is formed by plasma-enhanced chemical vapour deposition.

5. Process according to any one of the preceding claims, in which the chemical agent used in step b) is a fluid containing hydrofluoric acid.

6. Process according to claim 5, in which the fluid containing hydrofluoric acid is an aqueous or organic hydrofluoric acid solution.

7. Process according to claim 5, in which the fluid containing hydrofluoric acid is gaseous hydrofluoric acid, a mixture of gaseous hydrofluoric acid and a carrier gas, or else a mixture of hydrofluoric acid and supercritical carbon dioxide.

8. Process for fabricating an air-gap interconnect structure for integrated circuit, which comprises the implementation of a process for fabricating a hydrogenated amorphous silicon carbide film with through-pores according to any one of claims 1 to 7.
